# EUROPEAN PATENT APPLICATION

(11) **EP 4 712 342 A1**
(43) Date of publication of application: **18.03.2026**
(21) Application number: 24199716.2
(22) Date of filing: 11.09.2024
(51) Int. Cl.: H03F 1/30, H03F 3/195, H03F 3/24, H03F 3/45

(54) **GLOBAL BIASING IN A MULTICHANNEL RF TRANSCEIVER**

(71) Applicant: NXP B.V., 5656 AG Eindhoven (NL)
(72) Inventor: JANSSON, Lars Gustaf, 16446 Krista (SE); PUSA, Peter Fredrik, 16446 Krista (SE); DAHLIN, Jan Gunnar, 16446 Krista (SE)
(74) Representative: Hardingham, Christopher Mark

(57) **Abstract**

A multichannel RF transceiver includes a global biasing circuit (102) comprising: a reference current source (306), a reference diode (307), a first current mirror transistor (304) and a first replica impedance (310); and a plurality of second current mirror transistors (305_{1-N}), each having a gate connected to a gate of the first current mirror transistor (304). A plurality of RF amplifiers each comprise a second replica impedance (313) connected between a biasing node (314) connected to a drain of a respective one of the plurality of second current mirror transistors (305_{1-N}) and a first RF amplifier transistor (315) connected to an RF input (317) and to the biasing node (314). The first and second replica impedances (310, 313) cause a replica reference current (IReplicaref) through the first and second replica impedances (310, 313) to be smaller than a reference current (ICref) from the reference current source (306).

## Description

### Field

The disclosure relates to arrangements for global biasing of a multichannel RF transceiver comprising a plurality of local RF amplifiers connected to a global biasing circuit.

### Background

RF transceivers may comprise multiple transceiver modules, for example to provide beamforming capabilities to the transceiver. Such transceiver modules may be arranged in groups, for example with four groups of four individual transceivers arranged to provide a 16 channel beamforming transceiver having a common input and output signal path. RF amplifiers in each individual transceiver, which are present in both transmitting and receiving sides, require a biasing current to be provided through a transistor of the RF amplifier. To ensure that a uniform biasing current is provided to each RF amplifier, a common current source may provide a reference bias current that is replicated in each RF amplifier. This results, however, in a substantial increase in overall current used by the RF transceiver, which can in effect result in a current overhead of up to around 50% of the total current used. The overall power requirement therefore increases and efficiency reduces.

One possible solution to the above problem is to replicate a bias current in each RF amplifier using a small reference diode having a defined current density using a smaller current that is replicated via a current mirror as a larger biasing current in a larger amplifier transistor. A problem with this approach, however, is that the smaller transistor will tend to have a lower than expected current density, which has been found to fall off substantially as the emitter length falls below around 2 µm. This effect makes such a solution impractical for designs in which a uniform reference biasing current for each amplifier is a critical feature.

### Summary

According to a first aspect there is provided a multichannel RF transceiver having a plurality of transceiver modules, each transceiver module having an RF amplifier, the multichannel RF transceiver comprising a global biasing circuit having a biasing output connected to the RF amplifier in each of the plurality of transceiver modules, the global biasing circuit comprising: a reference current source and a reference diode connected in series between a supply voltage line and a common voltage line; a first current mirror transistor and a first replica impedance connected in series between the supply voltage line and the common voltage line; and a plurality of second current mirror transistors, each having a gate connected to a gate of the first current mirror transistor and a source connected to the supply voltage line, each RF amplifier in the plurality of transceiver modules comprising: a second replica impedance connected between a biasing node connected to a drain of a respective one of the plurality of second current mirror transistors and the common voltage line; and a first RF amplifier transistor having a base connected to an RF input and to the biasing node, wherein an impedance value of the first and second replica impedances is selected to cause a replica reference current through the first and second replica impedances to be smaller than a reference current from the reference current source.

The impedance value of the first and second replica impedances may be selected to cause the replica reference current to be less than half the reference current, optionally between around 0.2 and 0.01 of the reference current.

The global biasing circuit may comprise an op-amp having: an output connected to a node connecting the gates of the first and second current mirror transistors; a first input connected to a first node connecting the first replica impedance and first current mirror transistor; and a second input connected to a second node connecting the reference current source and reference diode.

The first input of the op-amp may be a non-inverting input and the second input an inverting input.

The reference diode may comprise an NPN bipolar transistor having collector and base connections connected together.

The first and second replica impedance may each comprise an NPN bipolar junction transistor in series with a resistor, the NPN bipolar junction transistor having base and collector terminals connected together.

The global biasing circuit may further comprise a beta helper transistor connected between the base and collector of a transistor connected as the reference diode. A reference base resistor may be connected between an emitter of the beta helper transistor and the base of the reference diode transistor. Each RF amplifier may comprise an amplifier base resistor connected between the biasing node and the base of the first amplifier transistor. A ratio between a value of the amplifier base resistor of each RF amplifier and a value of the reference base resistor may be equal to a ratio between an area of the reference diode and an area of the first amplifier transistor of each RF amplifier.

Each RF amplifier may comprise a second RF amplifier transistor connected in series with the first amplifier transistor, the second RF amplifier transistor arranged as a cascode transistor.

The first and second impedances may have equal impedance values.

Each RF amplifier may comprise a first RF choke connected between the biasing node and the base of the first RF amplifier transistor and a second RF choke connected between a supply voltage line of the RF transceiver and the first RF amplifier transistor. The supply voltage line of each RF amplifier may be connected to the supply voltage line of the global biasing circuit.

These and other aspects of the invention will be apparent from, and elucidated with reference to, the embodiments described hereinafter.

### Brief description of Drawings

Embodiments will be described, by way of example only, with reference to the drawings, in which:
Figure 1 is a simplified schematic diagram of a global biasing module connected to a plurality of transceiver modules;
Figure 2 is a schematic diagram illustrating an example global biasing module and associated inputs for defining and adjusting a reference current;
Figure 3 is a schematic circuit diagram illustrating an example global biasing module connected to a local RF amplifier;
Figure 4 illustrates an example replica impedance circuit; and
Figures 5a and 5b illustrate partial example implementations of the global biasing module and local RF amplifier of Figure 3.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

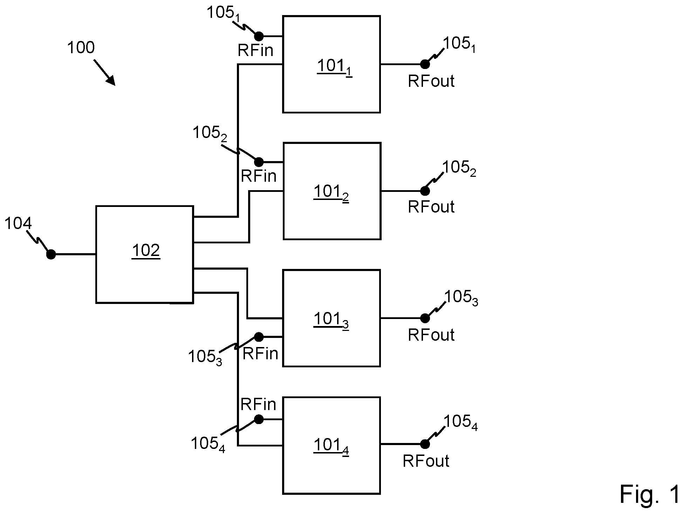

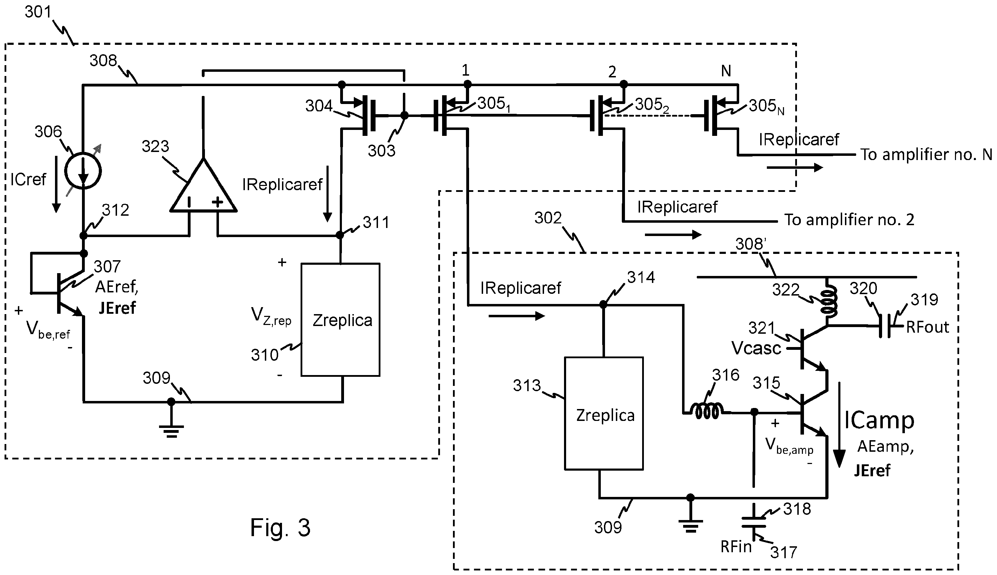

Figure 1 illustrates schematically an RF transceiver 100 having a plurality of transceiver modules 101₁₋₄ connected to a global biasing circuit 102. Each of the plurality of transceiver modules 101₁₋₄ comprises an RF amplifier (an example of which is described in more detail below with reference to Figure 3) that is connected to receive an amplifier bias current from the global biasing circuit 102. A bias control input signal is provided to an input 104 of the global biasing circuit 102 to control a level of the bias current that is replicated in each of the transceiver modules 101₁₋₄. Each of the transceiver modules 101₁₋₄ comprises an RF signal input 105₁₋₄ for receiving an RF signal RFin to be amplified and outputs an amplified RF signal RFout at an RF signal output 106₁₋₄. Each of the transceiver modules 101₁₋₄ may comprise more than one RF amplifier, for example one amplifier for a transmitter path and another amplifier for a receiver path, together with other components typically present in a transceiver module such as an antenna and modulator or demodulator.

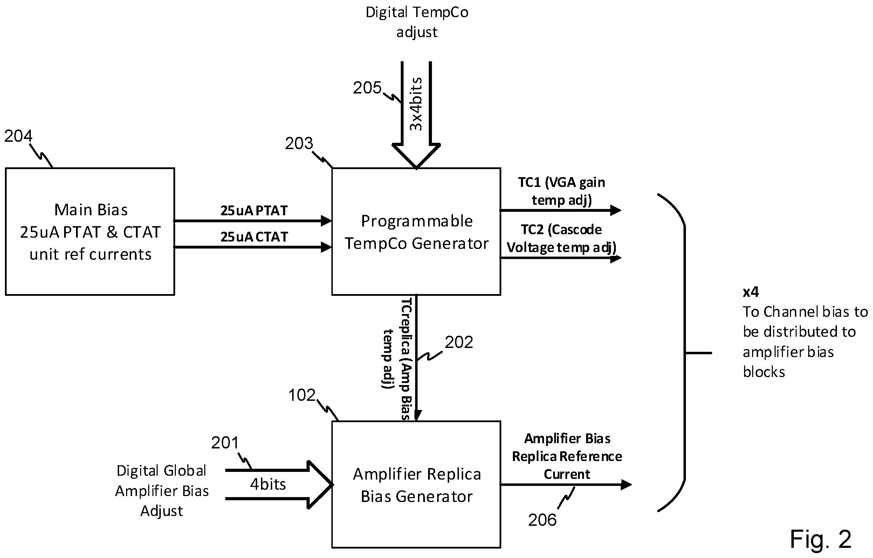

Figure 2 is a schematic diagram illustrating an example global biasing module 102, also termed an amplifier replica bias generator, together with associated modules for setting and adjusting an amplifier bias replica reference current defined by an output 206 of the global biasing module 102, which is distributed to multiple amplifier bias blocks. In this example, the output 206 defining the replica reference current is distributed to four amplifier bias blocks.

A digital global amplifier bias adjust signal 201 is provided to the global biasing module 102, in this example in the form of a 4 bit digital signal. In addition, a temperature adjustment signal 202 is provided by a programmable temperature compensation generator 203, which compensates for temperature variations. The temperature compensation generator 203 also provides further temperature compensation signals TC1, TC2 for adjusting a VGA (variable gain amplifier) gain and cascode voltage for each of the amplifier blocks. The temperature compensation generator 203 is provided with PTAT and CTAT reference currents by a main bias module 204 and a digital temperature compensation adjustment signal 205 from which the temperature adjustment signals 202, TC1, TC2 are derived.

Figure 3 illustrates schematically an example global biasing circuit 301 and one of a plurality of RF amplifiers 302, the global biasing circuit 301 corresponding to the amplifier replica bias generator or global biasing module 102 of Figure 2. The output 206 of Figure 2 corresponds to a replica reference current IReplicaref that is provided by the global biasing circuit 301 to each of the plurality of RF amplifiers 302.

The global biasing circuit 301 comprises a reference current source 306 that is connected in series with a reference diode 307 between a supply voltage line 308 and a common voltage line 309. The reference diode 307 is in this example in the form of an NPN bipolar junction transistor with base and collector connected together. The current source 306 provides a reference current ICref through the reference diode 307, which has a reference voltage Vbe,ref across its base and emitter connections. The reference diode 307 sets a reference emitter current density, JEref, which is replicated in the amplifier transistor 315 of each RF amplifier 302.

A first current mirror transistor 304 is connected in series with a first replica impedance 310 between the supply and common voltage lines 308, 309. The replica impedance 310 may comprise one or more resistive components and/or one or more transistors. The first and second replica impedances 310, 313 may for example comprise a resistor, an NMOS diode or an NPN transistor plus a resistor. The impedance value of the first replica impedance 310 results in a replica reference current IReplicaref flowing through the first current mirror transistor 304 and a replica voltage V_{Z,rep} set up across the first replica impedance 310.

Each of a plurality of second current mirror transistors 305_{1-N} has a gate connected to a gate of the first current mirror transistor 304 at node 303 and a source connected to the supply voltage line 308.

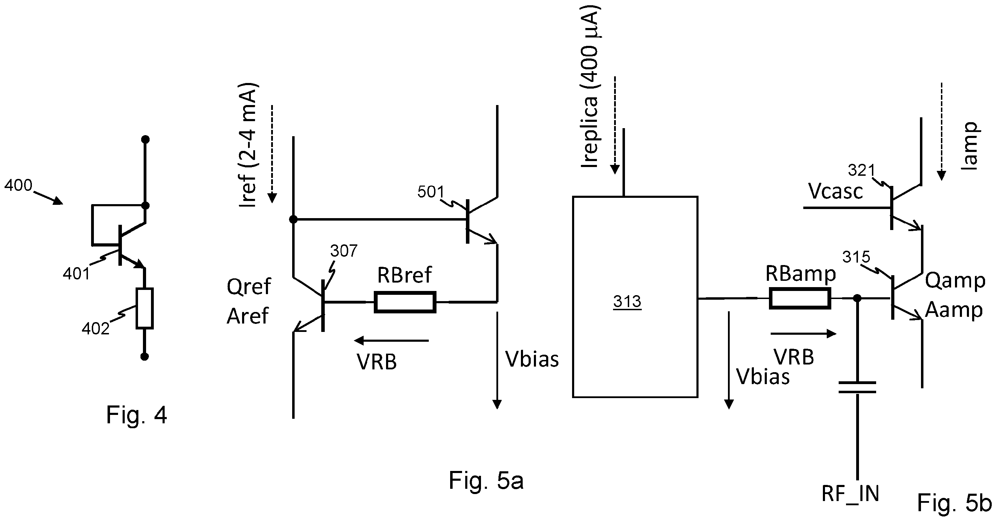

An NPN transistor in series with a resistor may be selected for each of the first and second replica impedances 310, 313 due to this arrangement having a low variation, given that matching the first and second replica impedances 310, 313 determines how closely the bias current is replicated in each RF amplifier. An example of a replica impedance circuit 400 for either of the first and second replica impedances 310, 313 is illustrated in Figure 4, in which an NPN bipolar junction transistor 401 with base and collector terminals connected together is connected in series with a resistor 402.

The reference diode 307 in the example in Figure 3 is shown as an NPN bipolar junction transistor with base and collector connected together. In a practical implementation, a beta helper transistor, also an NPN bipolar junction transistor, may be included between the base and collector of the transistor connected as the reference diode 307.

The first current mirror transistor 304 in this example is a P-channel FET having a source connected to the supply voltage line 308 and a drain connected to a first node 311 between the transistor 304 and the first replica impedance 310. A voltage at node 303 is set by the reference current ICref, reference diode 307 and replica impedance 310. This voltage is provided to the gate of each of the second current mirror transistors 305_{1-N}, which may also each be P-channel FETs, that have their gates connected to the node 303.

The global biasing circuit 301 may further comprise an op-amp (operational amplifier) 323, which has an output connected to the node 303 and inputs connected between the first node 311 and a second node 312 between the current source 306 and reference diode 307. The op-amp 323 ensures that the voltage V_{Z,ref} across the reference diode 307 and replica impedance 310 is equal. In this example, an inverting input of the op-amp 323 is connected to the second node 312 and a non-inverting input of the op-amp 323 is connected to the first node 311.

Through selection of the components of the replica impedance 310, the replica reference current IReplicaref can be made smaller than the reference current ICref. In an example, the reference current may be around 2.5 mA, while the replica reference current IReplicaref may be around 120 µA, i.e. less than 20 times that of the reference current. In a general aspect, the value of the replica impedance is selected such that the replica reference current is less than half that of the reference current, for example less than one fifth of the reference current, less than one tenth or one twentieth of the reference current. The replica reference current may for example be between around 0.2 and 0.05 of the reference current, between around 0.1 and 0.01 of the reference current or around 0.1 of the reference current. This choice results in the replica reference current that is distributed to each of the RF amplifiers 302 being smaller than the reference current ICref, which results in substantial overall current savings of N x (ICref - IReplicaref), where N is the number of RF amplifiers 302.

Each of the second current mirror transistors 305_{1-N} has a gate connected to a gate of the first current mirror transistor 304. The second current mirror transistors 305_{1-N} and a second replica impedance 313 in each RF amplifier 302, which has the same value as the first replica impedance 310, defines the same replica reference current IReplicaref in a bias circuit of each RF amplifier 302. As with the first current mirror transistor 304 and first replica impedance 310, each of the second current mirror transistor 305_{1-N} and second replica impedance 313 are connected in series between the supply voltage line 308 and common voltage line 309. A biasing node 314 between the second replica impedance 313 and second current mirror transistor 305_{1-N} is connected to a base connection of a first RF amplifier transistor 315, which in this example is an NPN bipolar junction transistor. The replica reference current IReplicaref through the replica impedance 313 results in the same voltage set up across the base and emitter connections of the first RF amplifier transistor 315, which defines a common-emitter current ICamp through the RF amplifier transistor 315. The current density JEref through the RF amplifier transistor is equal to the current density through the reference diode 307. Each of the RF amplifiers 302 is thereby biased similarly in line with the reference current ICref.

An RF input signal RFin is provided at an RF input connection 317 and provided to the base of the first RF amplifier transistor 315 via an input coupling capacitor 318. An RF output signal RFout is provided at an RF output connection 319, which is connected to the collector of the first RF amplifier transistor 315 via an output coupling capacitor 320. A second RF amplifier transistor 321 may be provided in series with the first RF amplifier transistor 315. The second RF amplifier transistor 321 is a cascode transistor, which is commonly used in RF amplifier circuits. The cascode transistor 315 is provided with a cascode voltage Vcasc at its base terminal.

A first RF choke inductor 316 is connected between the biasing node 314 and the base of the first RF amplifier transistor 315. A second RF choke inductor 322 is connected between the collector of the second RF amplifier transistor 321 and a supply voltage line 308' of the RF amplifier 302. The supply voltage line 308' may be the same as the supply voltage line 308 of the global biasing circuit 301 or may be a separate supply voltage line.

Figures 5a and 5b illustrate partial representations of an example global biasing circuit (Figure 5a) and a local RF amplifier circuit (Figure 5b), indicating that a bias voltage Vbias across the base-emitter of the transistor connected as the reference diode 307 is replicated across the base-emitter of the first RF amplifier transistor 315. A voltage V_{RB} across a base resistor RBamp connected between the second replica impedance circuit 313 and the base of the first RF amplifier transistor 315 needs to track a voltage across a base resistance RBref connected to the base of the transistor connected as the reference diode 307. In this example, a beta helper transistor 501 is connected to the transistor connected as the reference diode 307, with the base resistance RBref connected between an emitter of the beta helper transistor 501 and the base of the reference diode 307 and a base of the beta helper transistor 501 connected to the collector of the reference diode 307.

A ratio between the amplifier transistor current lamp and the reference current Iref is equal to a ratio of the area of the amplifier transistor 315 to the area of the reference diode 307, i.e. Iamp/Iref = Aamp/Aref, where Aamp is the area of the amplifier transistor 315 and Aref is the area of the reference diode 307. To maintain an equal base-emitter voltage across the reference diode 307 and the amplifier transistor 315, a ratio between a value of the amplifier base resistance RBamp in each RF amplifier and the reference base resistance RBref in the global biasing circuit is equal to the inverse of the above ratio of transistor areas, i.e. RBamp/RBref = Aref/Aamp.

From reading the present disclosure, other variations and modifications will be apparent to the skilled person. Such variations and modifications may involve equivalent and other features which are already known in the art of RF transceivers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A multichannel RF transceiver (100) having a plurality of transceiver modules (101₁₋₄), each transceiver module having an RF amplifier, the multichannel RF transceiver (100) comprising a global biasing circuit (102) having a biasing output connected to the RF amplifier in each of the plurality of transceiver modules (101₁₋₄), the global biasing circuit (102) comprising:
a reference current source (306) and a reference diode (307) connected in series between a supply voltage line (308) and a common voltage line (309);
a first current mirror transistor (304) and a first replica impedance (310) connected in series between the supply voltage line (308) and the common voltage line (309); and
a plurality of second current mirror transistors (305_{1-N}), each having a gate connected to a gate of the first current mirror transistor (304) and a source connected to the supply voltage line (308),
each RF amplifier (302) in the plurality of transceiver modules (101₁₋₄) comprising:
a second replica impedance (313) connected between a biasing node (314) connected to a drain of a respective one of the plurality of second current mirror transistors (305_{1-N}) and the common voltage line (309); and
a first RF amplifier transistor (315) having a base connected to an RF input (317) and to the biasing node (314),
wherein an impedance value of the first and second replica impedances (310, 313) is selected to cause a replica reference current (IReplicaref) through the first and second replica impedances (310, 313) to be smaller than a reference current (ICref) from the reference current source (306).

2. The multichannel RF transceiver (100) of claim 1, wherein the impedance value of the first and second replica impedances (310, 313) is selected to cause the replica reference current (IReplicaref) to be less than half the reference current (ICref), optionally between around 0.2 and 0.01 of the reference current (ICref).

3. The multichannel RF transceiver (100) of claim 1 or claim 2, wherein the global biasing circuit (301) comprises an op-amp (323) having:
an output connected to a node (303) connecting the gates of the first and second current mirror transistors (304, 305_{1-N});
a first input connected to a first node (311) connecting the first replica impedance (310) and first current mirror transistor (304); and
a second input connected to a second node (312) connecting the reference current source (306) and reference diode (307).

4. The multichannel RF transceiver (100) of claim 3, wherein the first input of the op-amp (323) is a non-inverting input and the second input of the op-amp (323) is an inverting input.

5. The multichannel RF transceiver (100) of any preceding claim, wherein the reference diode (307) comprises an NPN bipolar transistor having collector and base connections connected together.

6. The multichannel RF transceiver (100) of any preceding claim, wherein the first and second replica impedance (310, 313) each comprise an NPN bipolar junction transistor (401) in series with a resistor (402), the NPN bipolar junction transistor (401) having base and collector terminals connected together.

7. The multichannel RF transceiver (100) of any preceding claim, further comprising a beta helper transistor (501) connected between the base and collector of a transistor connected as the reference diode (307).

8. The multichannel RF transceiver (100) of claim 7 comprising a reference base resistor (RBref) connected between an emitter of the beta helper transistor (501) and the base of the reference diode (307).

9. The multichannel RF transceiver (100) of claim 8, wherein each RF amplifier comprises an amplifier base resistor (RBamp) connected between the biasing node (314) and the base of the first amplifier transistor (315).

10. The multichannel RF transceiver (100) of claim 9, wherein a ratio between a value of the amplifier base resistor (RBamp) of each RF amplifier (302) and a value of the reference base resistor (RBref) is equal to a ratio between an area (Aref) of the reference diode (307) and an area (Aamp) of the first amplifier transistor (315) of each RF amplifier (302).

11. The multichannel RF transceiver (100) of any preceding claim, wherein each RF amplifier (302) comprises a second RF amplifier transistor (321) connected in series with the first amplifier transistor (315), the second RF amplifier transistor (321) arranged as a cascode transistor.

12. The multichannel RF transceiver (100) of any preceding claim, wherein the first and second impedances (310, 313) have equal impedance values.

13. The multichannel RF transceiver (100) of any preceding claim, wherein each RF amplifier (302) comprises a first RF choke (316) connected between the biasing node (314) and the base of the first RF amplifier transistor (315) and a second RF choke (322) connected between a supply voltage line (308') of the RF transceiver (302) and the first RF amplifier transistor (315).

14. The multichannel RF transceiver (100) of claim 13, wherein the supply voltage line (308') of each RF amplifier (302) is connected to the supply voltage line (308) of the global biasing circuit (301).

## Amended claims

### Amended claims in accordance with Rule 137(2) EPC.

1. A multichannel RF transceiver (100) having a plurality of transceiver modules (101₁₋₄), each transceiver module having an RF amplifier, the multichannel RF transceiver (100) comprising a global biasing circuit (102) having a biasing output connected to the RF amplifier in each of the plurality of transceiver modules (101₁₋₄), the global biasing circuit (102) comprising:
a reference current source (306) and a reference diode (307) connected in series between a supply voltage line (308) and a common voltage line (309);
a first current mirror transistor (304) and a first replica impedance (310) connected in series between the supply voltage line (308) and the common voltage line (309); and
a plurality of second current mirror transistors (305_{1-N}), each having a gate connected to a gate of the first current mirror transistor (304) and a source connected to the supply voltage line (308),
each RF amplifier (302) in the plurality of transceiver modules (101₁₋₄) comprising:
a second replica impedance (313) connected between a biasing node (314) connected to a drain of a respective one of the plurality of second current mirror transistors (305_{1-N}) and the common voltage line (309); and
a first RF amplifier transistor (315) having a base connected to an RF input (317) and to the biasing node (314),
wherein an impedance value of the first and second replica impedances (310, 313) is selected to cause a replica reference current (IReplicaref) through the first and second replica impedances (310, 313) to be smaller than a reference current (ICref) from the reference current source (306);
wherein the global biasing circuit (301) comprises an op-amp (323) having:
an output connected to a node (303) connecting the gates of the first and second current mirror transistors (304, 305_{1-N});
a first input connected to a first node (311) connecting the first replica impedance (310) and first current mirror transistor (304); and
a second input connected to a second node (312) connecting the reference current source (306) and reference diode (307).

2. The multichannel RF transceiver (100) of claim 1, wherein the impedance value of the first and second replica impedances (310, 313) is selected to cause the replica reference current (IReplicaref) to be less than half the reference current (ICref), optionally between around 0.2 and 0.01 of the reference current (ICref).

3. The multichannel RF transceiver (100) of claim 1 or 2, wherein the first input of the op-amp (323) is a non-inverting input and the second input of the op-amp (323) is an inverting input.

4. The multichannel RF transceiver (100) of any preceding claim, wherein the reference diode (307) comprises an NPN bipolar transistor having collector and base connections connected together.

5. The multichannel RF transceiver (100) of any preceding claim, wherein the first and second replica impedance (310, 313) each comprise an NPN bipolar junction transistor (401) in series with a resistor (402), the NPN bipolar junction transistor (401) having base and collector terminals connected together.

6. The multichannel RF transceiver (100) of any preceding claim, further comprising a beta helper transistor (501) connected between the base and collector of a transistor connected as the reference diode (307).

7. The multichannel RF transceiver (100) of claim 6 comprising a reference base resistor (RBref) connected between an emitter of the beta helper transistor (501) and the base of the reference diode (307).

8. The multichannel RF transceiver (100) of claim 7, wherein each RF amplifier comprises an amplifier base resistor (RBamp) connected between the biasing node (314) and the base of the first amplifier transistor (315).

9. The multichannel RF transceiver (100) of claim 8, wherein a ratio between a value of the amplifier base resistor (RBamp) of each RF amplifier (302) and a value of the reference base resistor (RBref) is equal to a ratio between an area (Aref) of the reference diode (307) and an area (Aamp) of the first amplifier transistor (315) of each RF amplifier (302).

10. The multichannel RF transceiver (100) of any preceding claim, wherein each RF amplifier (302) comprises a second RF amplifier transistor (321) connected in series with the first amplifier transistor (315), the second RF amplifier transistor (321) arranged as a cascode transistor.

11. The multichannel RF transceiver (100) of any preceding claim, wherein the first and second impedances (310, 313) have equal impedance values.

12. The multichannel RF transceiver (100) of any preceding claim, wherein each RF amplifier (302) comprises a first RF choke (316) connected between the biasing node (314) and the base of the first RF amplifier transistor (315) and a second RF choke (322) connected between a supply voltage line (308') of the RF transceiver (302) and the first RF amplifier transistor (315).

13. The multichannel RF transceiver (100) of claim 12, wherein the supply voltage line (308') of each RF amplifier (302) is connected to the supply voltage line (308) of the global biasing circuit (301).
